# EUROPEAN PATENT SPECIFICATION

(11) **EP 3 246 722 B1**
(45) Date of publication and mention of the grant of the patent: **09.01.2019**
(21) Application number: 16382224.0
(22) Date of filing: 20.05.2016
(51) Int. Cl.: G01R 33/10, G07D 7/04

(54) **SYSTEMS AND METHODS FOR OBTAINING UNIQUE IDENTIFIERS AND MEASURING DISPLACEMENTS BY SENSING AND ANALIZING SPATIAL MAGNETIC FIELD VARIATIONS**
SYSTEME UND VERFAHREN ZUR GEWINNUNG VON EINMALIGEN IDENTIFIKATOREN UND MESSUNG VON VERSCHIEBUNGEN DURCH ERFASSUNG UND ANALYSE VON RÄUMLICHEN MAGNETFELDÄNDERUNGEN
SYSTÈMES ET PROCÉDÉS POUR OBTENIR DES IDENTIFIANTS UNIQUES ET MESURER DES DÉPLACEMENTS PAR DÉTECTION ET ANALYSE DES VARIATIONS DU CHAMP MAGNÉTIQUE SPATIAL

(43) Date of publication of application: 22.11.2017
(73) Proprietor: Fundación IMDEA Nanociencia, 28049 Madrid (ES)
(72) Inventor: PEDROSA RUIZ, Francisco Javier, 28049 MADRID (ES); CAMARERO DE DIEGO, Julio, 28049 MADRID (ES); BOLLERO REAL, Alberto, MADRID (ES)
(74) Representative: Arias Sanz, Juan

(56) References cited:
- WO-A1-2006/120825
- US-A1- 2001 028 246
- US-A1- 2011 031 960

## Description

### FIELD OF THE INVENTION

The present disclosure relates to methods, systems and computer program products for obtaining a unique identifier from a distinctive magnetic source such as e.g. an identification card.

The present disclosure further relates to methods, systems and computer program products for determining a relative spatial difference between two objects such as e.g. tectonic plates.

### BACKGROUND

Methods, systems and computer program products aimed at obtaining a unique identifier from a magnetic source (such as e.g. an identification card or label) are known in the prior art, which may be used for uniquely identifying people or objects. Once a person or object has been correctly identified, the person or object may be enabled for some kind of service or operation.

In some known examples, a correctly identified person may be enabled to access a building, or access confidential data (e.g. bank data), or perform sensitive operations (e.g. bank operations), etc. In other known examples, unique identification of objects may be useful in (big) stores, warehouses, customs, etc. with the aim of selecting a particular item for sale, or for its transportation to a point of sale, or for allowing its passage from one country to another, etc.

It is known that some of said prior art methods, systems and computer program products are based on reading a magnetic stripe in a card so that a holder of the card may be uniquely identified depending on a unique identifier magnetically encoded in the magnetic stripe. In this case, the information is stored (in the magnetic stripe) in magnetic domains representing ones and zeroes. Each of the magnetic domains may be understood as being a memory "cell" having only two possible values: zero and one.

A magnetic stripe reader may then read and decode said magnetic domains so as to obtain the unique identifier for performing corresponding validations. This manner of encoding/storing information in magnetic stripes may imply that information is stored with restricted storage density conditions, so that the number of different unique identifiers that can be encoded in the magnetic stripe may be certainly limited.

In the context of uniquely identifying objects/items, labels magnetically encoding/storing unique identifiers based on similar principles to those discussed above (with respect to magnetic stripe cards) may be attached to the objects/items. A suitable reader may be used to read said labels and decode their content in order to obtain the unique identifier and perform predefined validations. Also in this case, the storage density may be relatively low and, therefore, the number of different unique identifiers that can be encoded in a label may be excessively reduced.

There is thus a need for new methods, systems and computer program products for obtaining a unique identifier from a magnetic source (such as e.g. an identification card or label) that improve the prior art methods, systems and computer program products for such a purpose.

Further to that, determining relative spatial differences between two different objects may be useful in a variety of situations. It is known that some prior art methods, systems and computer program products are based on a first plate attached to a first object and a second plate attached to a second object, the first and second plates being in contact with each other. The first and second plates have substantially identical outlines, and they are initially positioned in such a way that the outlines substantially coincide with each other.

A camera is typically used to take a photo periodically of the contacting plates, and the photo is sent to a computing system for evaluation by an operator of possible discrepancies between the outlines of the contacting plates. The operator may then determine a relative spatial difference between the first and second objects depending on a discrepancy between the outlines of the contacting plates.

In this kind of contact-based systems (and methods and computer programs), some undesired relative motions between the objects that are being monitored may cause the break of the first and/or second contacting plates, in which case the system may result inoperable.

Moreover, these prior art systems (and methods and computer programs) only permit detecting relative spatial differences between objects in a two-dimensional basis, depending on whether one of the plates has "slid" or not with respect to the other plate. A relative spatial difference in a third dimension would result from e.g. a distancing between the plates, which would not be detected because the system is based on identifying discrepancies between the outlines of the plates.

Furthermore, these prior art systems (and methods and computer programs) do not provide an efficient and substantially on-line detection of relative spatial differences between objects, since it is based on taking a photo of the plates for subsequent evaluation by an operator of the system.

Hence, there is also a need for new methods, systems and computer program products for determining a relative spatial difference between a first object and a second object that improve the prior art methods, systems and computer program products for such an end.

### SUMMARY

The invention is defined by the independent claims. In one aspect, a method is provided for obtaining a unique identifier from a distinctive magnetic source that is configured to generate a magnetic field which is distinctively identifiable.

The method comprises receiving magnetic field intensity measurements from the distinctive magnetic source simultaneously and instantaneously obtained by an array of magnetic field sensor pairs relative to which the distinctive magnetic source is located in a predefined position.

The method further comprises determining, for one or more of the magnetic field sensor pairs, one or more magnetic field intensity differences between magnetic field sensors of each magnetic field sensor pair, depending on the corresponding magnetic field intensity measurements.

The method still further comprises assigning, for at least one of the determined magnetic field intensity differences, a predefined code associated with the magnetic field intensity difference between magnetic field sensors of each magnetic field sensor pair, based on an encoding scheme that maps magnetic field intensity differences to predefined codes.

The method yet further comprises forming the unique identifier for each assigned predefined code.

The proposed method permits reading unique identifiers that have been magnetically encoded with a significantly increased storage density, in comparison with prior art methods with the same or similar purposes. Accordingly, a significantly greater number of different unique identifiers may be encoded in the distinctive magnetic source and read by the method.

In the suggested method, the unique identifiers are formed depending on differences between magnetic field intensity measurements, which may take a relatively large diversity of values. Hence, with this approach, significantly larger quantities of different unique identifiers may be encoded and read in comparison with e.g. approaches interpreting binary values depending on a magnetization direction in magnetic domains.

The magnetic field intensity measurements are n-dimensional magnetic field intensity measurements, wherein n = 1 or 2 or 3. Said n-dimensional measurements may be obtained by a diversity of combinations of different types of sensors suitably arranged to sense the magnetic field intensity in the X and/or Y and/or Z dimensions. For example, three-dimensional (3D) measurements could be obtained by a single 3D sensor, or by one two-dimensional (2D) sensor and one one-dimensional (1D) sensor suitably arranged, or by three 1D sensors suitably arranged.

A 3D intensity measurement determined by a 3D magnetic field sensor comprises X, Y and Z intensity components defining a magnetic field vector at the spatial position where the measurement has been taken. A 3D magnetic field sensor may thus be seen as a memory "cell" having more or less possible values depending on the resolution of the sensor.

In an example based on a relatively low resolution, a magnetic field vector obtained from a 3D magnetic field sensor may have one of e.g. eight possible directions (0°, 45°, 90°, 135°, 180°, 225°, 270° and 315°). That is to say, eight different values may be obtained from each memory cell (or sensor). Hence, having e.g. fifteen 3D magnetic field sensors, up to 470.184.984.576 (= 8¹⁵) different unique identifiers could be encoded in the distinctive magnetic source and therefore read from the distinctive magnetic source by the suggested method.

Higher resolutions and greater numbers of magnetic field sensors (in arrays) may be considered to significantly increase the number of different unique identifiers that can be read by the proposed method. The sensors may be based on a diversity of technologies, such as e.g. AMR, GMR, TMR, PICK-UP COILS, HALL EFFECT, etc.

Another advantage of the suggested method may be that interferences caused by the earth's magnetic field may be avoided in the generation of the unique identifier. This is because the predefined codes are obtained from magnetic field intensity differences instead from "absolute" intensities measured by the sensors.

The earth's magnetic field affects in the same way all the measurements taken by the sensors. So the "absolute" intensities measured by the sensors (of the array of sensors) may vary depending on how the earth's magnetic field interferes with the magnetic field from the distinctive magnetic source. However, a difference between measurements taken by a pair of the sensors is always substantially the same because all the sensors are affected in the same way by the earth's magnetic field.

The pairs of magnetic field sensors may be predefined taking into account different criteria. For example, only pairs of neighbouring sensors or all the possible pairs that can be formed from the totality of sensors may be predefined to obtain the magnetic field intensity differences.

The magnetic field intensity measurements are obtained by the magnetic field sensors substantially simultaneously, i.e. substantially at the same time, and instantaneously. To this end, a trigger signal may be used to synchronize the magnetic field sensors to implement such simultaneous and instantaneous measures.

The magnetic field intensity measurements are simultaneously and instantaneously obtained by magnetic field sensors, i.e. according to a one-to-one basis. That is to say, each sensor generates a single measurement, and each of the measurements is received from a single sensor (in the array of magnetic field sensors).

The determination of predefined codes may be implemented in a similar way as e.g. characters are encoded using the ASCII coding scheme.

The encoding scheme used in the method may define relationships of different cardinalities between predefined codes and magnetic field intensity differences. For example, one predefined code may be determined from one magnetic field intensity difference (relation one-to-one). Similarly, the coding scheme may implement many-to-one and/or one-to-many and/or many-to-many relationships between predefined codes and magnetic field intensity differences.

The unique identifier may be formed by concatenating and/or interlacing the determined predefined codes, for example.

The distinctive magnetic source is an identification card comprising magnetic material randomly distributed in/on the card. This may permit obtaining identification cards that are very difficult to be reproduced for malicious purposes. In this case, a more secure method for obtaining a unique identifier (from the card with randomly distributed magnetic material) is provided.

In another aspect, a system is provided for obtaining a unique identifier from a distinctive magnetic source that is configured to generate a magnetic field which is distinctively identifiable.

The system comprises means for receiving magnetic field intensity measurements from the distinctive magnetic source simultaneously and instantaneously obtained by an array of magnetic field sensor pairs relative to which the distinctive magnetic source is located in a predefined position.

The system further comprises means for determining, for one or more of the magnetic field sensor pairs, one or more magnetic field intensity differences between magnetic field sensors of each magnetic field sensor pair, depending on the corresponding magnetic field intensity measurements.

The system still further comprises means for assigning, for at least one of the determined magnetic field intensity differences, a predefined code associated with the magnetic field intensity difference between magnetic field sensors of each magnetic field sensor pair, based on an encoding scheme that maps magnetic field intensity differences to predefined codes.

The system yet further comprises means for forming the unique identifier for each assigned predefined code.

The means comprised in the system may be electronic or computing means used interchangeably, that is, a part of the described means may be electronic means and the other part may be computer means, or all described means may be electronic means or all described means may be computer means. Examples of systems comprising only electronic means may be a CPLD (Complex Programmable Logic Device), an FPGA (Field Programmable Gate Array) or an ASIC (Application-Specific Integrated Circuit).

This system is suitable for performing the previously described method for obtaining a unique identifier from a distinctive magnetic source. Hence, the same or similar principles and advantages commented with respect to said method may be also attributed to this proposed system.

The magnetic field sensors are comprised in one or more arrays of sensors which may be substantially evenly distributed or not in the array. In the case that several of such arrays of sensors are comprised within the system, they may be stacked relative to each other, for example. In general, the more sensors included in the system, the greater may be the number of different unique identifiers that may be encoded by the proposed system (and read by the suggested method).

In some examples, an identifying system may be provided comprising a system for obtaining a unique identifier from a distinctive magnetic source (e.g. card or label) such as the one described before, the array of magnetic field sensor pairs, and a positioning system. The positioning system may be configured to guide the positioning of the distinctive magnetic source in the predefined position relative to the array of magnetic field sensor pairs.

According to examples of such an identifying system, the distinctive magnetic source may be an identification card comprising magnetic material randomly distributed in/on the identification card configured to generate the distinctively identifiable magnetic field. In alternative examples, the magnetic material may be uniformly distributed in/on the identification card.

In yet another aspect, a computing system is disclosed. The computing system may comprise a memory and a processor, embodying instructions stored in the memory and executable by the processor, the instructions comprising functionality to execute a method for obtaining a unique identifier from a distinctive magnetic source according to some examples disclosed herein.

The computing system may be a part of the system, i.e. a computing system inside the system, or may be the system itself. A communication network may be provided between the computing system and the system, for example a global communication network such as the Internet.

Information may be exchanged between the computing system and the system through such a communication network. Said communication may be secured by means of, for example, cryptographic keys and/or a SSL tunnel established between the computing system and the system.

In still another aspect, a computer program product is disclosed. The computer program product may comprise program instructions for causing a computing system to perform a method for obtaining a unique identifier from a distinctive magnetic source according to examples disclosed herein. The computing system executing the program instructions may be a part of the system (i.e. a sub-system inside the system configured to reproduce the method described above) or may be the system itself.

The computer program product may be embodied on a storage medium (for example, a CD-ROM, a DVD, a USB drive, on a computer memory or on a read-only memory) or carried on a carrier signal (for example, on an electrical or optical carrier signal).

The computer program may be in the form of source code, object code, a code intermediate source and object code such as in partially compiled form, or in any other form suitable for use in the implementation of the method. The carrier may be any entity or device capable of carrying the computer program.

For example, the carrier may comprise a storage medium, such as a ROM, for example a CD ROM or a semiconductor ROM, or a magnetic recording medium, for example a hard disk. Further, the carrier may be a transmissible carrier such as an electrical or optical signal, which may be conveyed via electrical or optical cable or by radio or other means.

When the computer program is embodied in a signal that may be conveyed directly by a cable or other device or means, the carrier may be constituted by such cable or other device or means.

Alternatively, the carrier may be an integrated circuit in which the computer program is embedded, the integrated circuit being adapted for performing, or for use in the performance of, the relevant methods.

In a further aspect, a method is provided for determining a relative spatial difference between a first object and a second object, wherein a magnetic field source configured to generate a magnetic field according to a predicted magnetic field lines model is attached to the first object, and wherein a sensor unit including magnetic field sensors is attached to the second object.

The method comprises receiving magnetic field intensity measurements from the magnetic field source simultaneously and instantaneously obtained by the magnetic field sensors.

The method further comprises determining, based on the received magnetic field intensity measurements and the predicted magnetic field lines model of the magnetic field source, a spatial position of the magnetic field source with respect to a location of the sensor unit, corresponding to the relative spatial difference between the first object and the second object.

This method may be used to determine various relative spatial differences between the first object and the second object at different times, and said relative spatial differences may be used to derive a relative motion between the first object and the second object.

The proposed method may permit using a contactless system for detecting relative spatial differences between objects, since the method is based on obtaining intensity measurements of a magnetic field generated by the magnetic field source. It is thus clear that no contact is needed between the magnetic field sensors and the magnetic field source, so that breakdowns due to undesired contacts are avoided.

The method may also allow a continuous on-line monitoring of relative spatial differences between the objects by continuously performing the method. In alternative implementations, the method may be performed with a predefined elapsed time between executions if e.g. a continuous execution is considered unnecessary.

The method may also permit determining relative motions in three dimensions (from various relative spatial differences) between the objects. In the particular case of two objects with respective vertical surfaces facing each other, the proposed method could permit determining relative spatial motions in all directions between said surfaces. For example, up/down, right/left, distancing/approaching motions (and any combination thereof) of one of the surfaces with respect to the other surface could be determined by the method.

The proposed method may also permit using a low-consumption system, since the magnetic field source may comprise permanent magnet(s), in some examples, and/or the magnetic field sensors may only need a low power supply to operate.

The suggested method may further allow using a system that may be resistant to adverse weather conditions, since the magnetic field source may comprise, in some examples, rusty magnets that cannot be further rusted due to adverse weather conditions.

As commented in other parts of the description, the magnetic field source is configured to generate a predicted magnetic field lines model. To this end, the magnetic field source may be configured in a diversity of manners so as to generate the predicted magnetic field lines model. For example, the magnetic field source may comprise several magnets suitably arranged with respect to each other according to the target magnetic field lines model.

Magnetic field vectors may be derived from the magnetic field intensity measurements, and said magnetic field vectors may be located in the magnetic field lines model.

Once the magnetic field vectors have been located in the magnetic field lines model, a relative spatial difference of the magnetic field source with respect to the sensor unit may be determined since the magnetic field lines model is defined relative to a "nuclear" position of the magnetic field source.

In general, the magnetic field intensity measurements may be n-dimensional magnetic field intensity measurements, wherein n = 1 or 2 or 3. Said n-dimensional measurements may be obtained by a diversity of combinations of different types of sensors suitably arranged to sense the magnetic field intensity in the X and/or Y and/or Z dimensions.

For example, three-dimensional (3D) measurements could be obtained by a single 3D sensor, or by one two-dimensional (2D) sensor and one one-dimensional (1D) sensor suitably arranged, or by three 1D sensors suitably arranged.

In some particular implementations, the magnetic field intensity measurements of the magnetic field may be three-dimensional (3D) magnetic field intensity measurements, each comprising X, Y and Z intensity components defining a magnetic field vector at the spatial position where the measurement has been taken. This may permit an increased accuracy of the method.

The 1D or 2D or 3D sensors may be based on a diversity of technologies, such as e.g. AMR, GMR, TMR, PICK-UP COILS, HALL EFFECT, etc.

In some examples, the method may be used to determine relative spatial differences (and relative motions) between tectonic plates. Alternatively, the method may be used to determine relative spatial differences (and relative motions) between different parts of a civil construction, or between a part of the civil construction and a part of another structure which is adjacent to the civil construction.

Further alternatively, the method may be used to determine relative spatial differences (and relative motions) between different elements arranged at a site in order to determine earthquake motions at the side. In yet further implementations, the method may be used in medical applications, such as to determine relative spatial differences (and relative motions) of e.g. an electrode or an endoscopic tip.

In yet a further aspect, a system is disclosed for determining a relative spatial difference between a first object and a second object, wherein a magnetic field source configured to generate a magnetic field according to a predicted magnetic field lines model is attached to the first object, and wherein a sensor unit including magnetic field sensors is attached to the second object.

The system comprises means for receiving magnetic field intensity measurements from the magnetic field source simultaneously and instantaneously obtained by the magnetic field sensors.

The system further comprises means for determining, based on the received magnetic field intensity measurements and the predicted magnetic field lines model of the magnetic field source, a spatial position of the magnetic field source with respect to a location of the sensor unit, corresponding to the relative spatial difference between the first object and the second object.

The magnetic field sensors may be comprised in one or more arrays of sensors which may be substantially evenly distributed or not in the array. In the case that several of such arrays of sensors are comprised within the system, they may be stacked relative to each other. In general, the more sensors included in the sensor unit, the greater may be the accuracy of the proposed system.

In some examples, a relative spatial difference detector may be provided comprising a system for determining a relative spatial difference between a first object and a second object, such as the one described before. The relative spatial difference detector may further comprise the magnetic field source and the sensor unit (including the magnetic field sensors).

In some configurations, the relative spatial difference detector may further comprise a first attachment system configured to attach the magnetic field source to the first object, and a second attachment system configured to attach the sensor unit to the second object.

In still a further aspect, a computing system is disclosed comprising a memory and a processor, embodying instructions stored in the memory and executable by the processor, the instructions comprising functionality to execute a method for determining a relative spatial difference between a first object and a second object such as the ones described before.

In an additional aspect, a computer program product is disclosed comprising program instructions for causing a computing system to perform a method for determining a relative spatial difference between a first object and a second object such as the ones described before.

These and other advantages and features will become apparent in view of the detailed description and drawings.

### BRIEF DESCRIPTION OF THE DRAWINGS

Non-limiting examples of the present disclosure will be described in the following, with reference to the appended drawings, in which:
Figure 1a schematically illustrates perspective views of two boards of magnetic field sensors suitable for systems according to examples.
Figure 1b schematically illustrates a perspective view of an identification card suitable for use with systems for obtaining a unique identifier according to examples.
Figure 1c schematically illustrates a side view of a sensor unit of a system for obtaining a unique identifier according to an example, and an identification card compatible with said system.
Figure 2 is a flow chart schematically illustrating a method for obtaining a unique identifier from a distinctive magnetic source according to an example.
Figure 3 is a schematic illustration of a system for determining a relative spatial difference between a first object and a second object, according to examples.
Figure 4a is a schematic illustration of a crack between tectonic plates and a system installed therein for determining relative spatial differences between the tectonic plates, according to further examples.
Figure 4b is a schematic illustration of a bridge and a system installed between two wall sections of the bridge for determining structural motions in the bridge, according to still further examples.
Figure 5 is a flow chart schematically illustrating a method for determining a relative spatial difference between a first object and a second object, according to examples.

### DETAILED DESCRIPTION

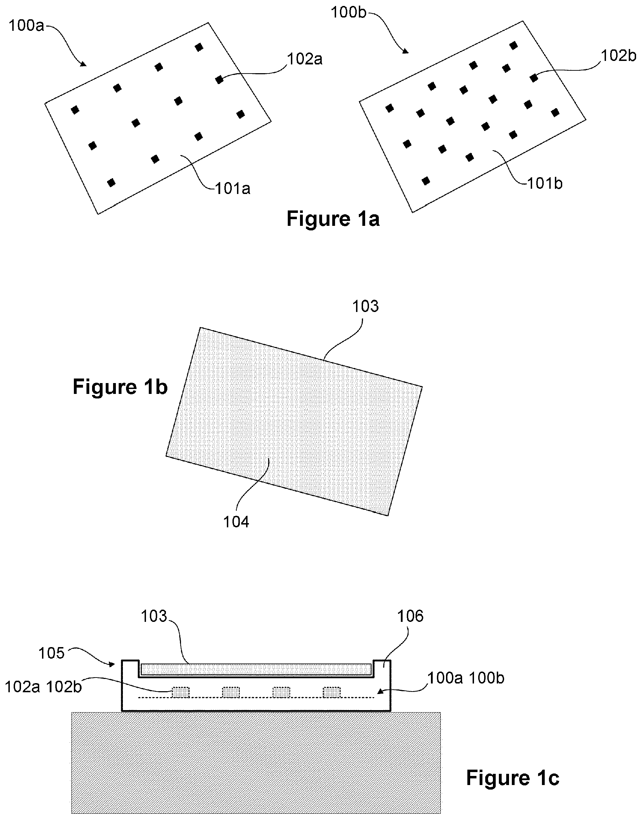

Figure 1a schematically illustrates perspective views of two boards of magnetic field sensors suitable for systems according to examples. The board 100a comprises a plate 101a of suitable material, and a 3 x 4 array of magnetic field sensors 102a. The board 100a may further comprise necessary circuitry (not shown) for governing the sensors 102a and communicating data produced by the sensors to e.g. a processing unit.

Similarly as in the board 100a, the other board 100b comprises a plate 101b and an array of magnetic field sensors 102b. One difference is that the board 100b comprises more sensors 102b than the board 100a. This may permit obtaining a greater quantity of measurements at the same time, which may provide an improved accuracy and the capacity of reading larger amounts of data in the context of e.g. obtaining a unique identifier (from a magnetic source) and/or determining a relative spatial difference between objects.

Figure 1b schematically illustrates a perspective view of an identification card suitable for a system for obtaining a unique identifier according to examples. An identification card 103 of this type may be designed according to a variety of shapes, sizes and compositions. The identification card 103 may comprise magnetic material 104 distributed in/on the card 103 for generating a distinctively identifiable magnetic field which may serve e.g. to uniquely identify the owner/holder of the card 103. The magnetic material 104 may be e.g. micro-particles of magnetic material, small pieces of permanent magnets, etc.

Figure 1c schematically illustrates a side view of a sensor unit of a system for obtaining a unique identifier according to an example, and an identification card compatible with said system. The identification card 103 may be similar to the one of the previous figure. The sensor unit may comprise a casing and a board 100a, 100b similar to the one shown in Figure 1a. The board 100a, 100b is depicted with dashed lines to indicate its arrangement inside the casing of the sensor unit 105, so the board 100a, 100b should not be visible in the particular view provided.

The casing of the sensor unit 105 may comprise a ledge 106 extending along a rim of the casing, for guiding (or assisting) the positioning of the card 103 in a predefined position with respect to the sensors 102a, 102b. This predefined position may be such that the same magnetic field intensity differences are always derived for the same card 103, independently from the affection of the earth's magnetic field in the magnetic field intensity measurements produced by the sensors 102a, 102b. The card 103 may be comprised in the system or not.

The system may also comprise a processing unit (not shown) which may be arranged locally with the sensor unit 105 or may be located at a remote location. The processing unit may be, in some examples, integrated with the board 100a, 100b. In case that the processing unit is external to the sensor unit 105, the sensors 102a, 102b and the processing unit (or computing system) may be connected with each other through a wired connection or a wireless connection. If the computing system is at a remote location, this connection may be used to connect the sensors 102a, 102b and the computing system through a communications network, such as e.g. the Internet.

The processing unit may be implemented by computing means, electronic means or a combination thereof. The computing means may be a set of instructions (that is, a computer program) and then the processing unit may comprise a memory and a processor, embodying said set of instructions stored in the memory and executable by the processor. The instructions may comprise functionality to execute at least a method for obtaining a unique identifier from a magnetic source such as an identification card (or label), as will be disclosed below.

In case the processing unit is implemented only by electronic means, the processing unit may be, for example, a CPLD, an FPGA or an ASIC. In case the processing unit is a combination of electronic and computing means, the computing means may be a set of instructions and the electronic means may be any electronic circuit capable of implementing the corresponding step or steps of the cited method.

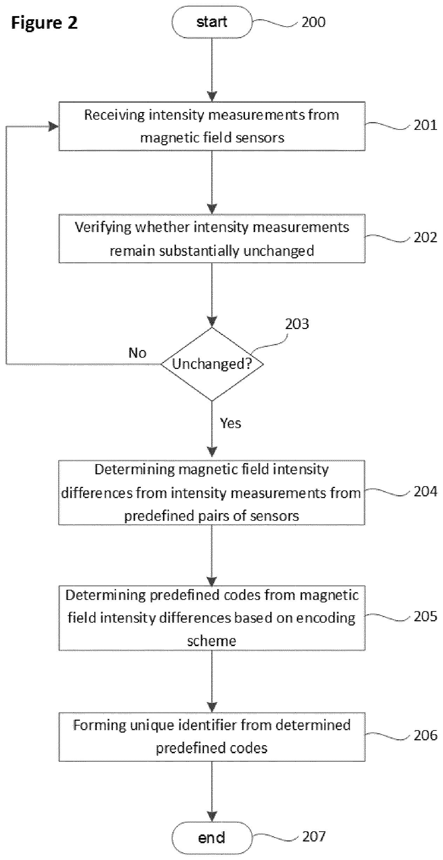

Figure 2 is a flow chart schematically illustrating a method for obtaining a unique identifier from a distinctive magnetic source (e.g. identification card or label) according to an example. This method may be performed by the processing unit of the system described before with reference to Figure 1c, so that reference numbers of said figure may be used along the description of this method.

The method may start at block 200 when, for example, a transition is detected from absence of the card 103 (zero values measured by the sensors 102a, 102b) to presence of the card 103 (significant increase of the magnetic field measured by the sensors 102a, 102b). This transition may be detected by suitable electronics of the sensor board 100a, 100b, in which case a trigger signal indicating the starting of the method may be sent to the computing system.

At block 201, the processing unit (or computing system) may start receiving magnetic field intensity measurements of the distinctively identifiable magnetic field generated by the card 103, from the magnetic field sensors 102a, 102b through e.g. corresponding connection. This reception of magnetic field intensity measurements may be continuously performed at an initial stage.

At next block 202, a verification of whether the continuously received magnetic field intensity measurements remain substantially unchanged may be performed. This may permit ensuring that the card 103 is well positioned (in the predefined position) with respect to sensors 102a, 102b (as shown in Figure 1c).

At decision block 203, in case of positive result of said verification, the method may proceed to block 204 because the card 103 has been considered as being arranged in the predefined position with respect to sensors 102a, 102b.

In case of negative result of said verification (performed at block 202) the method may loop back to block 201 because the card 103 has been considered as not being well positioned with respect to the sensors 102a, 102b. This transition from block 203 to block 201 may be performed up to a predefined number of times, after which an error indicating a wrong position of the card 103 may be issued.

At block 204, predefined pairs of the magnetic field sensors may be considered for determining a magnetic field intensity difference value for each of said predefined pairs of sensors. The magnetic field intensity difference may be an absolute difference (subtraction) between the magnetic field intensity measurements produced by the magnetic field sensors in the pair of sensors.

At block 205, predefined codes may be determined from the magnetic field intensity differences determined in previous block 204. This may be performed based on an encoding scheme configured to map magnetic field intensity differences to predefined codes. In other words, the determined magnetic field intensity differences may be encoded in a similar way as e.g. characters are encoded using the ASCII coding scheme.

In some examples, a coding scheme may be used wherein one predefined code is derived from one magnetic field intensity difference (one-to-one relationship). Alternatively, a coding scheme may be employed in which one predefined code is determined from several magnetic field intensity differences (one-to-many relationship). Further alternatively, a coding scheme may be utilized wherein several predefined codes are derived from one magnetic field intensity difference (many-to-one relationship).

At block 206, the unique identifier may be formed taking into account the predefined codes determined at previous block 205. The formation of the unique identifier may be performed in a diversity of manners, such as e.g. concatenating the predefined codes, interlacing the predefined codes, transforming the predefined codes based on arithmetic operations, etc.

In a particular example, first and second magnetic field intensity differences may be determined, the first magnetic field intensity difference corresponding to code 'A12B5', and the second magnetic field intensity difference corresponding to code 'CCC6A'. These codes 'A12B5' and 'CCC6A' generated based on corresponding encoding scheme may then be used to form the unique identifier by e.g. concatenating the codes, which would produce the identifier 'A12B5CCC6A'. Alternatively, the unique identifier may be formed by interlacing the codes, which would yield the identifier 'AC1C2CB65A'.

Once the unique identifier has been obtained, the computing system may check its existence in a database of identifiers and data associated thereto. If the identifier exists in the database, consequent actions may be undertaken, such as e.g. enabling the holder of the card to enter a building, or to access sensitive data, or to perform sensitive electronic operations, etc.

At block 207, the method may be ended.

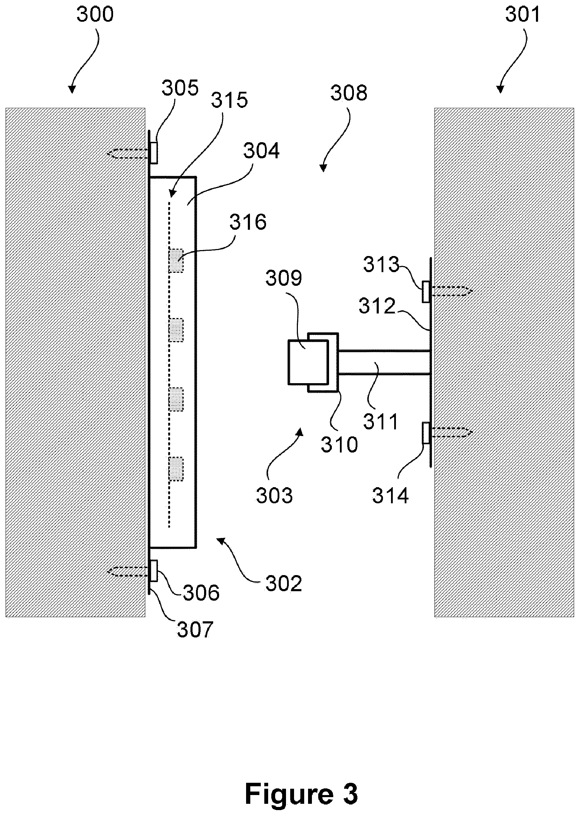

Figure 3 is a schematic illustration of a system 308 for determining a relative spatial difference between a first object 300 and a second object 301, according to examples.

The system 308 is shown comprising a sensor unit 302 and a magnetic field generator 303. The system 308 may comprise an attaching system based on e.g. screws 305, 306 for attaching the sensor unit 302 to one of the first and second objects 300, 301. The system 308 may comprise an attaching system based on e.g. screws 313, 314 for attaching the magnetic field generator 303 to the other of the first and second objects 300, 301.

The sensor unit 302 may comprise a casing 304 housing a board 315 of sensors 316 which may be distributed in a diversity of manners on the board 315. The sensor unit 302 may further comprise a support plate 307 coupled to the casing 304 in such a way that the sensor unit 302 may be attached to one of the first and second objects 300, 301 with the support plate 307 screwed to said object 300, 301.

The magnetic field generator 303 may comprise a magnetic field source 309 such as e.g. one or more permanent magnets, electromagnets, a combination thereof, etc. and a holder 310 configured to hold the magnetic field source 309. The magnetic field generator 303 may further comprise a rod 311 or similar (such as e.g. a spring) connecting the holder 310 with a support plate 312. The support plate 312 may be configured in such a way that the magnetic field generator 303 may be attached to the other of the first and second objects 300, 301 with the support plate 312 screwed to this object 300, 301.

As shown in the figure, both the sensor unit 302 and the magnetic field generator 303 may be configured in such a way that, when installed, the sensors 316 and the magnetic field source 309 are positioned relative to each other so that the sensors 316 receive the magnetic field created by the magnetic field source 309. Changes in the magnetic field may be interpreted as changes in the relative spatial difference between the objects 300, 301.

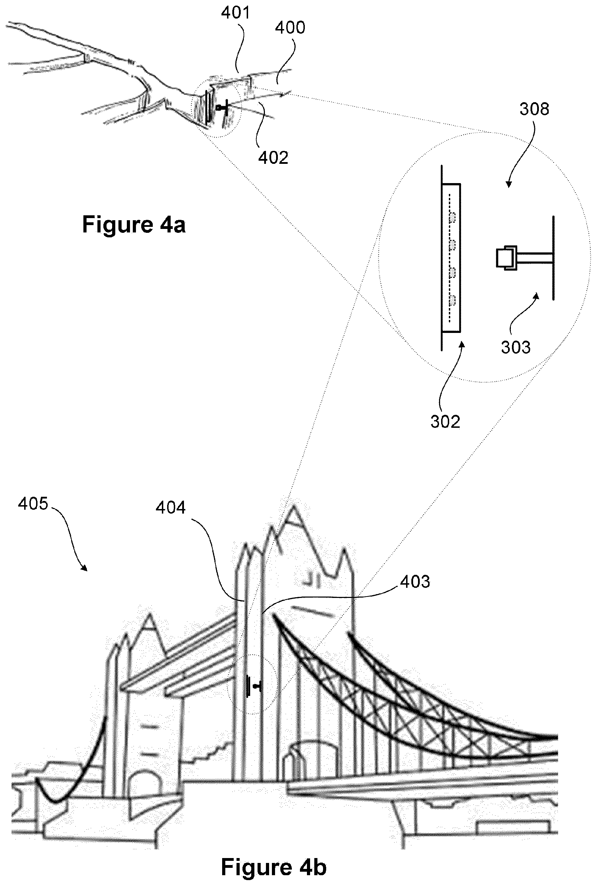

Figure 4a is a schematic illustration of a crack 400 between tectonic plates 401, 402 and a system 308 installed therein for determining relative spatial differences (and relative motions) between the tectonic plates 401, 402, according to further examples. An enlarged view of the system 308 is provided in the figure, reflecting that said system 308 is similar to the one illustrated in Figure 3. In particular, the system 308 is shown comprising a sensor unit 302 and a magnetic field source 303 similar to those included in the system of Figure 3.

Figure 4b is a schematic illustration of a bridge 405 and a system 308 installed between two wall sections 403, 404 of the bridge 405 for determining structural motions in the bridge, according to still further examples. Also in this case, a system 308 similar to the one illustrated in Figure 3 may be used for detecting structural motions in the bridge 405.

In the particular example shown, the system 308 is installed between different parts of the same bridge. However, in alternative examples, the system 308 may be installed in such a way that relative spatial differences (and relative motions) may be detected between the bridge or a part of the bridge 405 and another structure adjacent to the bridge 405 or a part of said adjacent structure. A structure adjacent to the bridge 405 may be, for example, a road connected by the bridge, a ground region on which the bridge is supported, another bridge "concatenated" with the bridge 405 to form a macro bridge structure, etc.

In the above context, one of the sensor unit 302 and the magnetic field source 303 may be attached to a part of the bridge 405 and the other of the sensor unit 302 and the magnetic field source 303 may be attached to a part of the adjacent structure.

In general, a system similar to the system 308 may be used for detecting relative spatial differences (and relative motions) in the context of any type of civil structures, according to the same or similar principles described above with reference to Figure 4b. Examples of such civil structures may be e.g. buildings, roads on the ground, elevated roads, water supply structures, etc.

In other examples, a system for determining an earthquake motion at a site may be also provided. Such a system may comprise a system 308 similar to the ones shown in Figures 3, 4a and 4b. In this particular case, the sensor unit 302 may be attached to an object arranged at the site and the magnetic field source 303 may be attached to another object arranged at the site. Such objects may include e.g. domestic furniture, street furniture, building floor, etc. A support element specifically aimed at holding the sensor unit 302 and/or the magnetic field source 303 so that the sensor unit 302 receives the magnetic field generated by the magnetic field source 303 can also be used in the context of these examples.

The system 308 may also comprise a processing unit (not shown) which may be arranged locally with the sensor unit 302 or may be at a remote location. The processing unit may be in some examples integrated with the sensor board 315. In case that the processing unit is external to the sensor unit 302, the sensors 316 and the processing unit (or computing system) may be connected with each other through a wired connection or a wireless connection. If the computing system is at a remote location, this connection may be used to connect the sensors 316 and the computing system through a communications network, such as e.g. the Internet.

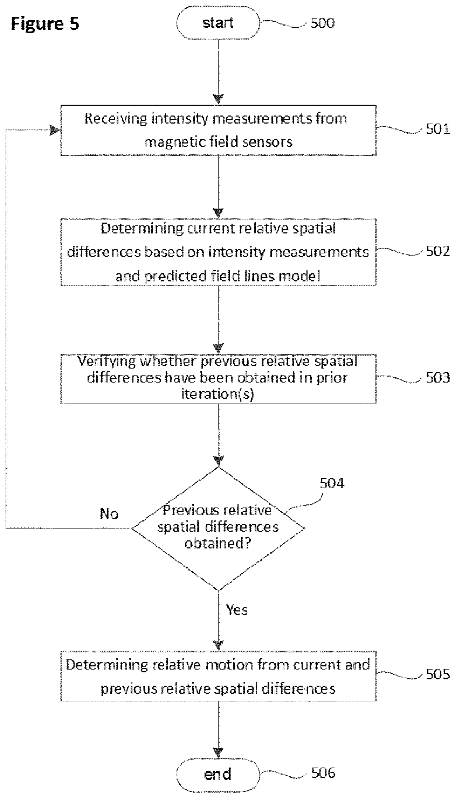

Figure 5 is a flow chart schematically illustrating a method for determining relative spatial differences and relative motion between a first object and a second object, according to an example. This method may be performed by the computing unit of a system similar to those described with reference to Figures 3, 4a and 4b. Hence, reference numbers of said figures may also be used along the description of this method.

The sensor unit 302 of the system 308 may be attached to one of the first and second objects, and the magnetic field source 303 may be attached to the other of the first and second objects.

The method may start at block 500 when, for example, a trigger signal is inputted in the computing system through corresponding functionality aimed at that, or received from the sensor unit 302 of the system 308.

The sensor unit 302 may send such a trigger signal when a transition is detected from absence of motion to minimal presence of motion, i.e. when a minimal variation in the measurements produced by the sensors 316 occurs. This transition may be detected by suitable electronics of the sensor board 315. The method may also be started periodically or may be performed continuously.

At block 501, the processing unit (or computing system) may receive magnetic field intensity measurements from the magnetic field sensors 315 through corresponding connection.

At block 502, current relative spatial differences of the magnetic field source with respect to the sensor unit 302, may be derived from the received magnetic field intensity measurements and a predicted magnetic field lines model of the magnetic field source. This derivation may be performed by using any known algorithm aimed at determining relative spatial differences of a magnetic field source with respect to the sensor unit 302, depending on magnetic field intensity measurements (of the magnetic field) generated by the sensors in the sensor unit 302. No details about said algorithms are provided herein because they are known in the technical field of the present disclosure and so they are not an object of the present disclosure.

The magnetic field lines model may have been predicted by suitably designing the magnetic field source so as to generate a magnetic field according to the magnetic field lines model. An experimental verification of the magnetic field lines model may also be carried out once the magnetic field source has been constructed.

In particular examples, the magnetic field intensity measurements may be three-dimensional (3D) magnetic field intensity measurements, each comprising X, Y and Z intensity components defining a magnetic field vector at the spatial position where the measurement has been taken. An absolute intensity and a direction of the magnetic field at that spatial position may thus be derived from the magnetic field vector.

Conceptually, a given magnetic field vector may be located in a position of the magnetic field lines model depending on the intensity and orientation associated to the vector. A mapping between the "measured" magnetic field vectors and the magnetic field lines model may be performed so as to locate the magnetic field vectors in the magnetic field lines model.

Once the magnetic field vectors have been located in the magnetic field lines model, the relative spatial difference of the magnetic field source with respect to the sensor unit 302 may be determined since the magnetic field lines model is defined relative to a "nuclear" position of the magnetic field source.

The location of the magnetic field vectors in the magnetic field lines model may be determined with a certain error. Any known error minimization algorithm may thus be used to reduce this error to an acceptable value.

At block 503, a verification may be performed of whether previous relative spatial differences between the magnetic field source and the sensor unit have been obtained in previous executions of the method.

At decision block 504, in case of positive result of said verification, the method may proceed to block 505 because different relative spatial differences (between the magnetic field source and the sensor unit) corresponding to different times are available.

Otherwise, i.e. in case of negative result of the verification performed at block 504, the method may loop back to block 501 because no previous relative spatial differences (between the magnetic field source and the sensor unit) are available. The reception of magnetic field intensity measurements is thus performed again.

At block 505, the relative motion between the first object and the second object may be determined depending on current relative spatial differences between the magnetic field source and the sensor unit (obtained at block 502) and previous relative spatial differences between the magnetic field source and the sensor unit (from prior executions of the method).

At block 506, the method may be finalized with e.g. the storage in a repository of the relative spatial differences between the magnetic field source and the sensor unit obtained in this execution, to be used in next executions of the method.

Although only a number of particular embodiments and examples of the invention have been disclosed herein, it will be understood by those skilled in the art that other alternative embodiments and/or uses of the invention and obvious modifications and equivalents thereof are possible. Furthermore, the present invention covers all possible combinations of the particular embodiments described. Thus, the scope of the present invention should not be limited by particular embodiments, but should be determined only by a fair reading of the claims that follow.

Further, although the examples described with reference to the drawings comprise computing apparatus/systems and processes performed in computing apparatus/systems, the invention also extends to computer programs, particularly computer programs on or in a carrier, adapted for putting the system into practice.

## Claims

1. An identifying method comprising a method of obtaining a unique identifier from a distinctive magnetic source (103) that is configured to generate a magnetic field which is distinctively identifiable, and that is positioned in a predefined position relative to an array of magnetic field sensor pairs (102a, 102b) through a positioning system (106) configured to guide such a positioning of the distinctive magnetic source (103); wherein
the distinctive magnetic source is an identification card (103) comprising magnetic material (104) randomly distributed in/on the identification card (103) configured to generate the distinctively identifiable magnetic field; and wherein the identifying method comprises:
receiving (201) n-dimensional magnetic field intensity measurements, wherein n = 1 or 2 or 3, from the distinctive magnetic source (103) simultaneously and instantaneously obtained by the array of magnetic field sensor pairs (102a, 102b), relative to which the distinctive magnetic source (103) is located in the predefined position, **characterized by**
determining (204), for one or more of the magnetic field sensor pairs, one or more magnetic field intensity differences between magnetic field sensors of each magnetic field sensor pair, depending on n-dimensional vectors representing corresponding n-dimensional magnetic field intensity measurements,
assigning (205), for at least one of the determined magnetic field intensity differences, a predefined code associated with the magnetic field intensity difference between magnetic field sensors of each magnetic field sensor pair, based on an encoding scheme that maps magnetic field intensity differences to predefined codes, and
forming (206) the unique identifier for each assigned predefined code.

2. An identifying system comprising a system for obtaining a unique identifier from a distinctive magnetic source (103) that is configured to generate a magnetic field which is distinctively identifiable; an array of magnetic field sensor pairs (102a, 102b); and a positioning system (106) configured to guide the positioning of the distinctive magnetic source (103) in a predefined position relative to the array of magnetic field sensor pairs (102a, 102b); wherein
the distinctive magnetic source is an identification card (103) comprising magnetic material (104) randomly distributed in/on the identification card (103) configured to generate the distinctively identifiable magnetic field; and wherein the system for obtaining a unique identifier comprises:
means for receiving (201) n-dimensional magnetic field intensity measurements, wherein n = 1 or 2 or 3, from the distinctive magnetic source (103) simultaneously and instantaneously obtained by the array of magnetic field sensor pairs (102a, 102b) relative to which the distinctive magnetic source (103) is located in the predefined position, **characterized by**
means for determining (204), for one or more of the magnetic field sensor pairs, one or more magnetic field intensity differences between magnetic field sensors of each magnetic field sensor pair, depending on n-dimensional vectors representing corresponding n-dimensional magnetic field intensity measurements,
means for assigning (205), for at least one of the determined magnetic field intensity differences, a predefined code associated with the magnetic field intensity difference between magnetic field sensors of each magnetic field sensor pair, based on an encoding scheme that maps magnetic field intensity differences to predefined codes, and
means for forming (206) the unique identifier for each assigned predefined code.

3. A computing system comprising a memory and a processor, embodying instructions stored in the memory and executable by the processor, the instructions comprising functionality to execute an identifying method according to claim 1.

4. A computer program product comprising program instructions for causing a computing system to perform an identifying method according to claim 1.

5. A computer program product according to claim 4, embodied on a storage medium and/or carried on a carrier signal.

## Patentansprüche

1. Identifizierungsverfahren, umfassend ein Verfahren zur Gewinnung eines eindeutigen Identifizierungsmerkmals von einer distinkten Magnetquelle (103), welche zur Erzeugung eines eindeutig identifizierbaren Magnetfelds ausgebildet ist und durch ein Positionierungssystem (106), welches zur Führung einer Positionierung der distinkten Magnetquelle (103) ausgebildet ist, gegenüber einer Anordnung von Magnetfeldsensorpaaren (102a, 102b) in einer vorbestimmten Position positioniert wird; wobei
die distinkte Magnetquelle eine Identifizierungskarte (103) ist, welche ein zufällig in/auf der zur Erzeugung des eindeutig identifizierbaren Magnetfelds ausgebildeten Identifizierungskarte (103) verteiltes magnetisches Material (104) umfasst; und wobei das Identifizierungsverfahren Folgendes umfasst:
Empfangen (201) n-dimensionaler Magnetfeldstärkenmessungen, wobei n = 1 oder 2 oder 3, von der distinkten Magnetquelle (103), die gleichzeitig und unmittelbar durch die Anordnung von Magnetfeldsensorpaaren (102a, 102b) gewonnen werden, gegenüber welchen die distinkte Magnetquelle (103) in der vorbestimmten Position angeordnet ist,
**gekennzeichnet durch**
Bestimmen (204) mindestens eines Magnetfeldstärkenunterschieds zwischen Magnetfeldsensoren jedes Magnetfeldsensorpaars für mindestens eines der Magnetfeldsensorpaare in Abhängigkeit von n-dimensionalen Vektoren, welche entsprechende n-dimensionale Magnetfeldstärkenmessungen darstellen,
Zuordnen (205) eines mit dem Magnetfeldstärkenunterschied zwischen Magnetfeldsensoren jedes Magnetfeldsensorpaars verknüpften vorbestimmten Codes zu mindestens einem der bestimmten Magnetfeldstärkenunterschiede anhand eines Codierungsschemas, welches Magnetfeldstärkenunterschiede auf vorbestimmte Codes abbildet, und
Bilden (206) des eindeutigen Identifizierungsmerkmals für jeden zugeordneten vorbestimmten Code.

2. Identifizierungssystem umfassend ein System zur Gewinnung eines eindeutigen Identifizierungsmerkmals von einer distinkten Magnetquelle (103), die zur Erzeugung eines eindeutig identifizierbaren Magnetfelds ausgebildet ist; eine Anordnung von Magnetfeldsensorpaaren (102a, 102b); und ein Positionierungssystem (106), welches zur Führung der Positionierung der distinkten Magnetquelle (103) in eine vorbestimmte Position gegenüber der Anordnung von Magnetfeldsensorpaaren (102a, 102b) ausgebildet ist; wobei die distinkte Magnetquelle eine Identifizierungskarte (103) ist, welche ein zufällig in/auf der zur Erzeugung des eindeutig identifizierbaren Magnetfelds ausgebildeten Identifizierungskarte (103) verteiltes magnetisches Material (104) umfasst; und wobei das System zur Gewinnung eines eindeutigen Identifizierungsmerkmals Folgendes umfasst:
Mittel zum Empfangen (201) n-dimensionaler Magnetfeldstärkenmessungen, wobei n = 1 oder 2 oder 3, von der distinkten Magnetquelle (103), die gleichzeitig und unmittelbar durch die Anordnung von Magnetfeldsensorpaaren (102a, 102b) gewinnbar sind, gegenüber welchen die distinkte Magnetquelle (103) in der vorbestimmten Position angeordnet ist,
**gekennzeichnet durch**
Mittel zum Bestimmen (204) mindestens eines Magnetfeldstärkenunterschieds zwischen Magnetfeldsensoren jedes Magnetfeldsensorpaars für mindestens eines der Magnetfeldsensorpaare in Abhängigkeit von n-dimensionalen Vektoren, welche entsprechende n-dimensionale Magnetfeldstärkenmessungen darstellen,
Mittel zum Zuordnen (205) eines mit dem Magnetfeldstärkenunterschied zwischen Magnetfeldsensoren jedes Magnetfeldsensorpaars verknüpften vorbestimmten Codes zu mindestens einem der bestimmten Magnetfeldstärkenunterschiede anhand eines Codierungsschemas, welches Magnetfeldstärkenunterschiede auf vorbestimmte Codes abbildet, und
Mittel zum Bilden (206) des eindeutigen Identifizierungsmerkmals für jeden zugeordneten vorbestimmten Code

3. Computersystem, umfassend einen Speicher und einen Prozessor, wobei das Computersystem in dem Speicher gespeicherte und durch den Prozessor ausführbare Befehle enthält, wobei die Befehle Funktionen zur Ausführung eines Identifizierungsverfahrens nach Anspruch 1 umfassen.

4. Computerprogrammprodukt, umfassend Programmbefehle, mittels welcher ein Computersystem zur Ausführung eines Identifizierungsverfahrens nach Anspruch 1 ansteuerbar ist.

5. Computerprogrammprodukt nach Anspruch 4, welches auf einem Speichermedium vorliegt und/oder auf einem Trägersignal übertragbar ist.

## Revendications

1. Un procédé d'identification comprenant un procédé d'obtention d'un identificateur unique à partir d'une source magnétique distinctive (103) qui est configurée pour générer un champ magnétique qui est distinctivement identifiable, et qui est positionnée dans une position prédéfinie par rapport à un réseau de paires (102a, 102b) de capteurs de champ magnétique à travers un système (106) de positionnement configuré pour guider un tel positionnement de la source magnétique distinctive (103) ; dans laquelle
la source magnétique distinctive est une carte d'identification (103) comprenant un matériau magnétique (104) distribué aléatoirement dans la carte d'identification (103) configurée pour générer le champ magnétique distinctivement identifiable ; et dans laquelle le procédé d'identification comprend :
le fait (201) de recevoir de mesures d'intensité de champ magnétique à n dimensions, n étant égal à 1 ou 2 ou 3, depuis la source magnétique distinctive (103), obtenues simultanément et instantanément par le réseau de paires (102a, 102b) de capteurs de champ magnétique, par rapport auxquelles la source magnétique distinctive (103) est située dans la position prédéterminée, **caractérisé par**
le fait (204) de déterminer, pour une ou plusieurs des paires de capteurs de champ magnétique, une ou plusieurs différences d'intensité de champ magnétique entre des capteurs de champ magnétique de chaque paire de capteurs de champ magnétique, en fonction de vecteurs à n dimensions représentant des mesures correspondantes d'intensité de champ magnétique à n dimensions,
le fait (205) d'attribuer, pour au moins l'une des différences d'intensité de champ magnétique déterminées, un code prédéfini associé à la différence d'intensité de champ magnétique entre des capteurs de champ magnétique de chaque paire de capteurs de champ magnétique, sur la base d'un schéma de codage qui cartographie les différences d'intensité de champ magnétique en des codes prédéfinis, et
le fait (206) de former l'identifiant unique pour chaque code prédéfini attribué.

2. Un système d'identification comprenant un système pour obtenir un identificateur unique à partir d'une source magnétique distinctive (103) qui est configurée pour générer un champ magnétique qui est distinctivement identifiable ; un réseau de paires (102a, 102b) de capteurs de champ magnétique ; et un système (106) de positionnement configuré pour guider le positionnement de la source magnétique distinctive (103) dans une position prédéfinie par rapport au réseau de paires (102a, 102b) de capteurs de champ magnétique ; dans lequel
la source magnétique distinctive est une carte d'identification (103) comprenant un matériau magnétique (104) distribué aléatoirement dans/sur la carte d'identification (103) configurée pour générer le champ magnétique distinctivement identifiable ; et dans lequel le système pour obtenir un identificateur unique comprend :
des moyens pour recevoir (201) des mesures d'intensité de champ magnétique à n dimensions, n étant égal 1 ou 2 ou 3, depuis la source magnétique distinctive (103) simultanément et instantanément obtenues par le réseau de paires (102a, 102b) de capteurs de champ magnétique par rapport auxquelles la source magnétique distinctive (103) est située dans la position prédéterminée, **caractérisé par**
des moyens pour déterminer (204), pour une ou plusieurs des paires de capteurs de champ magnétique, une ou plusieurs différences d'intensité de champ magnétique entre des capteurs de champ magnétique de chaque paire de capteurs de champ magnétique, en fonction de vecteurs à n dimensions représentant des mesures correspondantes d'intensité de champ magnétique à n dimensions,
des moyens pour attribuer (205), pour au moins l'une des différences d'intensité de champ magnétique déterminées, un code prédéfini associé à la différence d'intensité de champ magnétique entre des capteurs de champ magnétique de chaque paire de capteurs de champ magnétique, sur la base d'un schéma de codage qui cartographie les différences d'intensité de champ magnétique en des codes prédéfinis, et
un moyen pour former (206) l'identificateur unique pour chaque code prédéfini attribué.

3. Un système informatique comprenant une mémoire et un processeur, incluant des instructions stockées dans la mémoire et exécutables par le processeur, les instructions comprenant une fonctionnalité pour mettre en oeuvre un procédé d'identification selon la revendication 1.

4. Un produit de programme d'ordinateur comprenant des instructions de programme pour amener un système informatique à mettre en oeuvre un procédé d'identification selon la revendication 1.

5. Un produit de programme d'ordinateur selon la revendication 4, placé sur un support de stockage et/ou transporté sur un signal porteur.
